(19) Europäisches Patentamt
European Patent Office
Office européen des brevets

(11) Publication number: **0 223 748 B1**

# (12) EUROPEAN PATENT SPECIFICATION

(45) Date of publication of patent specification: **17.07.91**

(51) Int. Cl.5: **G01R 27/26**, G01N 22/00, G01R 27/06

(21) Application number: **86830332.2**

(22) Date of filing: **06.11.86**

## (54) Method and apparatus for determining the content of unburnt coal in an ash from a combustion heater.

(30) Priority: **08.11.85 IT 951585**

(43) Date of publication of application:
**27.05.87 Bulletin 87/22**

(45) Publication of the grant of the patent:
**17.07.91 Bulletin 91/29**

(84) Designated Contracting States:
**AT BE CH DE ES FR GB GR LI LU NL SE**

(56) References cited:

| | |
|---|---|
| EP-A- 0 069 969 | DE-A- 3 317 215 |
| FR-A- 2 560 998 | US-A- 3 025 463 |
| US-A- 3 701 943 | US-A- 4 104 584 |

**ELECTRONICS LETTERS, vol. 9, no. 2, 25th January 1973, pages 39,40, Hitchin, GB; M. KENT: "Rapid method suitable for liquids and powders for determination of relative permittivities in the microwave region"**

(73) Proprietor: **CONSIGLIO NAZIONALE DELLE RICERCHE**
**Piazzale Aldo Moro, 7**
**I-00185 Roma(IT)**

Proprietor: **ENTE NAZIONALE PER L'ENERGIA ELETTRICA - (ENEL)**
**Via G.B. Martini 3**
**I-00198 Roma(IT)**

(72) Inventor: **Bramanti, Mauro**
**Via Comunale 171/173 Valdicastello Carducci**
**Pietrasanta Lucca(IT)**
Inventor: **Del Bravo, Andrea**
**1, via Romiti**
**Pisa(IT)**

(74) Representative: **Bardini, Marco Luigi et al**
**c/o Società Italiana Brevetti S.p.A. Piazza di Pietra 39**
**I-00186 Roma(IT)**

**EP 0 223 748 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

1982 IEEE MTT-S INTERNATIONAL MICROWAVE SYMPOSIUM DIGEST, Dallas, Texas, US, 15th-17th June 1982, pages 325-327; G.E. EVERETT et al.: "A computer-controlled dielectric constant measurement system: the moving vane dielectometer"

4TH EUROPEAN MICROWAVE CONFERENCE PROCEEDINGS, Montreux, CH, 10th-13th September 1974, pages 66-70; J. MUSIL et al.: "New microwave system to determine the complex permittivity of small dielectric and semiconducting samples"

## Description

The present invention relates to a method and an apparatus for determining the dielectric constant of a material, said dielectric constant being important, inter alia, for determining the unburnt coal content in the ash coming from a heater of any kind. Such a measure is especially useful when testing a heater whose structure is still in an experimental condition, because it is obviously correlated to the heater efficiency.

The only known method for measuring the content of unburnt coal in the ash is to perform a chemical analysis of the ash itself. This method is often unsuitable because in most cases the parameter would have to be known in real time. On the other hand, very often, the knowledge of said parameter is not requested with a high degree of accuracy, as attainable through the chemical analysis method.

It is known that the dielectric constant of a dielectric material is a function of the content of conductive particles in the material: the higher the conductive particles' concentration, the higher will be the dielectric constant of the material, both as far as its real part and imaginary part are concerned.

In particular the coal ash without unburnt coal has the characteristic of a substantially perfect dielectric material, i.e. with a very low value of the imaginary part of the dielectric constant.

On the contrary, unburnt coal has a conductivity substantially other than zero. Therefore, in the presence of unburnt coal in the ash the dielectric constant increases as a function of the unburnt concentration.

The increase affects both the real part and the imaginary part of the dielectric constant; thus, in order to have a thorough evaluation of the phenomenon, in the following reference will be made to the modulus of the dielectric constant, except when specified to the contrary.

The present technical knowledge teaches that a biunivocal correspondance exists between the concentration of unburnt coal in the ash and the dielectric constant of the ash itself. The theoretical study of the problem with the purpose of making analytically explicit such a biunivocal correspondance, is not necessary. What is necessary is only a calibration curve which can be easily obtained from several samples of ash characterized by known unburnt concentrations measured, for example, by chemical analysis.

The calibration curve being known, the technical problem is therefore how to measure the ash dielectric constant in a quick and easy way. Unfortunately the methods and apparatuses that have been proposed up to now, involve the use of samples of well defined shape and also are unsuitable for characterizing materials having comparatively high losses.

As abovesaid, the concept of deriving information about the nature of a material under test by a measurement of electrical parameters when the material is subjected to a radio frequency signal is per se not new.

For instance EPA 0069969 discloses a microwave alcohol fuel sensor wherein microwaves are made to interact with the fuel for instance by means of a stripline immersed in the fuel and measuring the amount of energy reflected by said stripline, said amount changing according to whether the fuel is constituted solely of gasoline or a mixture gasoline-alcohol or alcohol only. Even if the apparatus disclosed in the EPA is suitable for determining the relative amounts of gasoline/alcohol, it does not provide sufficient information for the needs above referred to according to the invention, because the disclosed apparatus provides no information about the phase of the reflected signal. As a matter of fact it operates solely on the modulus of the reflection coefficient.

US-P-3 035 463 Luoma et al, discloses an apparatus for the measurement of complex reflection coefficient. The apparatus disclosed in this reference relies on a microwave interferometry technique for deriving both the modulus and phase of the microwave energy reflected by a material under test. This apparatus, even if it provides all the information about the dielectric constant of a material under test, requires many costly precision components and the disclosed measurement method is rather cumbersome. Moreover, the component utilized must be precision-engineered owing to the intrinsic needs of interferometry techniques, that make them unsuitable for the harsh environment of a combustion heater.

The object of the present invention is to provide an apparatus and a method for the measurement of the dielectric constant of a material, in particular ash from a combustion heater, capable of being actuated without the necessity of shaping the material to be tested into shapes which are difficult to make.

It is another object of the present invention to provide an apparatus of the above mentioned type of low cost and which is easy to operate without any special training.

According to the invention, the apparatus for determining the content of unburnt coal in an ash coming from a combustion heater has the features defined in claim 1.

Furthermore, the method for determining the content of unburnt coal in an ash coming from a combustion heater according to the invention is defined in claim 6.

One way of carrying out the invention is described in detail below with reference to drawings which

illustrate only one specific embodiment, in which:

Figure 1 is a schematic diagram of the apparatus according to the invention;

Figure 2 shows the phase ratio of the signals $V_3$ and $V_4$ shown in figure 1 and, respectively, of the signals $V^+$ and $V^-$ detectable in the microstrip, in correspondance to the section A-A of figure 1, when the microstrip is unloaded; and

Figure 3 shown the same signals of Figure 2 when the microstrip is loaded.

For a better understanding of the operating principle of the apparatus according to the present invention, it is necessary to set out some elements about the microstrips for transmission of high frequency signals.

A microstrip is a strip of conductive material of width W separated from a conductive plane of width approximately ten times greater than W by means of a substrate of dielectric constant $\epsilon_1$ and thickness d'.

Since the substrate is constituted by a perfect dielectric material, its dielectric constant is real. When a sample of dielectric material of height d, width equal (or greater) than that of the conductive plane and dielectric constant $\epsilon_2$ is placed on the microstrip, the latter is said "loaded". As the loading material generally has a conductivity other than zero, this would be generally complex. It can be demonstrated that the characteristic impedance of the loaded microstrip is given by

$$Z_o = \frac{1}{c \pi \varepsilon_o} \sqrt{\frac{\underset{\sim}{I}}{I_o}} \qquad (1)$$

where:

c = free space light velocity

$\epsilon_0$ = vacuum dielectric constant.

$$I = \int_0^1 \frac{\left\{1,6 \frac{\sin\left(\frac{1-x}{x}\right)}{\frac{1-x}{x}} + \frac{2,4}{\left(\frac{1-x}{x}\right)^2}\left[\cos\left(\frac{1-x}{x}\right) - 2\frac{\sin\left(\frac{1-x}{x}\right)}{\frac{1-x}{x}} + \frac{\sin^2\left(\frac{1-x}{x}\right)}{\left(\frac{1-x}{x}\right)^2}\right]\right\}^2}{\left[\underset{\sim}{\varepsilon}_2 \frac{\varepsilon_2 \, tgh\left(\frac{2d}{w}\,\frac{1-x}{x}\right)+1}{\underset{\sim}{\varepsilon}_2 + tgh\left(\frac{2d}{w}\,\frac{1-x}{x}\right)} + \frac{\varepsilon_1}{tgh\left(\frac{2d'}{w}\,\frac{1-x}{x}\right)}\right] x\,(1-x)} \, d_x \qquad (2)$$

and

$$I_o = I \quad \text{when} \quad \underset{\sim}{\varepsilon}_2 = \varepsilon_1 = 1 \qquad (3)$$

It has to be pointed out that generally $\underset{\sim}{I}$ is complex if $\underset{\sim}{\varepsilon}_2$ is complex; on the contrary, $I_o$ is always real.

Referring now to the Figure 1, a microstrip 10 has been short-circuited and loaded with a material placed in a container 9 for a length $1_o$. The material 11 has a characteristic dielectric constant $\epsilon_2$. In this case the input impedance for the section A-A of Figure 1 is given by:

$$\underset{\sim}{Z}_{in} = J\underset{\sim}{Z}_o \cdot tg\, \underset{\sim}{\beta}\, 1_o \qquad (4)$$

where $\underset{\sim}{Z}_o$ is the characteristic impedance of the loaded microstrip and

$$\underset{\sim}{\beta} = \frac{2}{\lambda}\sqrt{\underset{\sim}{\varepsilon}_e} \qquad (5)$$

λ being the wave length in the free space and

$$\varepsilon_e = \frac{I_o}{I} \qquad (6)$$

As is known, the reflection coefficient $\Gamma$ for the section A-A is given by

$$\Gamma = \frac{Z_{in} - Z_A}{Z_{in} + Z_A} \qquad (7)$$

where $Z_A$ is the characteristic impedance of the not loaded microstrip.

Putting

$$\rho = \frac{1}{\nu/2} \qquad (8)$$

we obtain

$$\Gamma = \frac{-Z_A + j\frac{\sqrt{I\,I_o}}{c\pi\varepsilon_o}\,tg\left[\pi\rho\sqrt{\frac{I_o}{I}}\right]}{Z_A + j\frac{\sqrt{I\,I_o}}{c\pi\varepsilon_o}\,tg\left[\pi\rho\sqrt{\frac{I_o}{I}}\right]} \qquad (9)$$

This equation shows that the reflection coefficient $\Gamma$, beside depending on the dielectric constant $\varepsilon_2$ of the loading material, also depends, through I and $I_0$, on the following parameters:

w = linear length of the microstrip,
d' = substrate height,
$\epsilon_1$ = substrate dielectric constant,
d = height of the loading material.

The first three parameters depend on the type of microstrip used and therefore are known; the fourth parameter depends on the height of the sample placed on the microstrip.

It can be easily understood that, if the height d of the sample is greater than a certain minimum value, the reflection coefficient $\Gamma$ no longer depends on said parameter; in order to let the reflexion coefficient become independent of this parameter, it is sufficient to use material samples of height greater than a minimum d value.

For instance, using a microstrip of the type known as POLIGUIDE having a vacuum characteristic impedance of 50Ω, the physical parameters of the microstrip are the following:

d' = 1.6 mm
w = 4.8 mm
$\epsilon 1$ = 2.32

As regards the fourth parameter, a minimum value $d_1$ of 7.5 cm approximately has been found for d.

The last parameter affecting the reflexion coefficient $\Gamma$ is $1_0$ and this parameter can be directly measured once for all measurements. Thus, as can be seen in Figure 1, to the microstrip 10 there has been fixed a suitable container 9 made of plexiglass where the material to be tested has been placed for a length equal to $1_0$.

Microwaves generating means 1 supplies microwaves to a power divider 2 whose output is constituted by two perfectly in phase signals. The first signal is directly sent to a mixer 3 and this signal will be indicated at $V_3$ in the following. The second signal is sent to a circulator 5 by which it is sent to the microstrip 10, which, being shortcircuited, sends it back to the circulator 5. Furthermore circulator 5 sends the signal back to mixer 3 via phase shifters 6 and 7 ($V_4$). The mixer output is fed to a zero detector 4, in the present case a voltmeter. A power measuring device 8, in the present case a wattmeter, is also associated with microstrip 10.

The measure of the modulus of the reflexion coefficient is immediate, being sufficient to measure the

output power from the microstrip 10 by means of wattmeter 8 in both cases, i.e. when the microstrip is loaded (power value equal to $P_2$) and when the microstrip is not loaded ($P_1$). The modulus of the reflexion coefficient is given by:

$$|\underset{\sim}{\Gamma}| = \sqrt{\frac{P_2}{P_1}} \qquad (10)$$

From the foregoing it is understood that it is now required to only measure the phase of the reflexion coefficient in the section A-A of Figure 1.

Indicating at $V^+$ the signal, i.e. the wave, entering the microstrip in correnspondance of the section A-A and at $V^-$ the signal, i.e. the wave, coming back from the same section, the phase of the reflection coefficient is the phase angle between the two signals, i.e.

$$\angle \underset{\sim}{\Gamma} = \angle \frac{V^-}{V^+} \qquad (11)$$

It has to be considered that mixer 3 provides an output voltage equal to zero when the signals $V_3$ and $V_4$ at its input ends are in quadrature, i.e. shifted 90° out of phase. Therefore, it is easy to control when these signals are shifted 90° out of phase by means of the zero measurer 4 and the line delay can be varied by operating the not calibrated phase shifter 6. Assuming the microstrip not loaded at the beginning and putting the signals $V_3$ and $V_4$ in quadrature by controlling this operation with the zero detector 4, the signal situation is that graphically illustrated in Figure 2 by means of the phase diagrams. The angle $\phi$ is the phase of the reflection coefficient of the not loaded microstrip and can be easily calculated theoretically. In fact, this angle is given by:

$\phi = \pi - 2\,\beta\,1_o$ (12)

where

$$\beta = \frac{2\,\pi}{\lambda}\sqrt{\varepsilon_e} \qquad (13)$$

and

$$\varepsilon_e = \frac{I_o}{I} \qquad (14)$$

I being the integral (2) when the loaded material is air, i.e. the microstrip is not loaded. Putting again $\rho = 1_o/\lambda/2$ and substituting in (12), it is obtained

$$\varphi = \pi - 2\,\pi\,\rho\sqrt{\frac{I_o}{I}} \qquad (15)$$

With the previously defined values of the various parameters, it is:
$I_o = 0.594311$
$I = 0.302328$

If now the microstrip is loaded, as schematically shown in Figure 1, with a sample of length $1_o$, the signal $V^-$ will be further delayed with respect to the signal $V^+$ of an angle $\vartheta$ and of the same angle will be delayed $V_4$ with respect to $V_3$.

The actual phase situation is visualized in Figure 3 and the angle

$$\gamma = \phi + \vartheta$$

is the phase of the reflection coefficient in correspondance of the section A-A of the loaded microstrip. The angle $\phi$ being known, the angle $\vartheta$ remains to be determined. Due to the delay of $V_4$ with respect to $V_3$, the output of mixer 3 is now unbalanced. This is visualised by the zero detector 4. The measure of the angle $\vartheta$ is performed by means of calibrated phase shifter 7. In fact, if by means of the latter the output of mixer 3 is set to zero again, this means that phasor $V_4$ will be in advance just of the angle $\vartheta$. Therefore this parameter can be directly read from the calibrated phase shifter 7. It has to be pointed out that the zero setting does not depend on possible amplitude variations of the signal $V_4$. The apparatus schematically shown in Figure 1 obviously operates in the field of the microwaves, i.e. having a frequency greater than 1 GHz. The selection of the proper frequency value is anyway affected by the following considerations:

- the frequency value must be consistent with the use of microstrip type transmission lines;
- it is advisable that the value be in a range where compact and easy to be found electronic components are available;
- this value must be so that

$$\rho = \frac{2\, l_o}{\lambda} < 0.8$$

in order to avoid any ambiguity about the determination of the angle $\vartheta$. An optimum value balancing the various requirements is about 2 GHz.

In the particular case where the tested material is ash coming from a combustion heater, having determined the phase and the modulus of the reflexion coefficient, it is possible to calculate the dielectric constant and then, by means of the previously prepared calibration curve, obtain the amount of unburnt coal present in the ash.

As can be appreciated, according to the invention the value of the dielectric constant is obtained by means of a low cost apparatus, that does not require the use of samples of particular shape or amount. Furthermore the initial zero setting in the absence of the material to be tested, makes the measure unaffected by any deviation of the real apparatus from what was assumed by the theory.

## Claims

**1.** Apparatus for determining the content of unburnt coal in an ash coming from a combustion heater, wherein said content is determined by means of the measurement of the dielectric constant of said ash, said apparatus being characterized in that it comprises:

- a short-circuited microstrip (10) and container means (9) associated therewith, for maintaining said ash (11) in contact with said microstrip;
- microwave generating means (1) for feeding microwaves to said microstrip (10) and providing a reference signal ($V_3$);
- non reciprocal means (5) for extracting the reflected signal ($V_4$) from said microstrip (10);
- means for detecting the phase displacement (3, 4) between said reference signal ($V_3$) and said signal ($V_4$) reflected by said microstrip (10), said means comprising a mixer (3) and a voltmeter (4);
- power measuring means (8) applied to said microstrip for providing the modulus of the reflection coefficient;
- control means (6, 7) for varying said phase displacement by varying the phase between said reference signal ($V_3$) and said reflected signal ($V_4$), said control means (6, 7) measuring by a null technique the phase displacement between said signals, whereby the value of the dielectric constant can be obtained from the modulus of the reflection coefficient and the phase thereof which is a function of said phase displacement measure.

**2.** Apparatus according to the claim 1, wherein said container means (9) has a side perpendicular to said microstrip (10) the length of said side being greater than a minimum value $d_1$ to make the reflection coefficient independent of this parameter, said value $d_1$ being a function of said ash and said microstrip.

3. Apparatus according to any of the previous claims, wherein said means for detecting the phase displacement between the reference and the reflected signals comprises a mixer (3) having said signals as an input and a voltage signal equal to zero as an output, when said signal are in quadrature, and a voltmeter (4) for detecting said voltage signal.

4. Apparatus according to any of the previous claims wherein said control means comprises a first phase shifter (6) for 90° phase displacing the signal reflected by the microstrip, under no-load condition, with respect to said reference signal and a second calibrated phase shifter (7) for 90° phase displacing the signal reflected by the microstrip, under load condition, with respect to said reference signal.

5. An apparatus according to any of the previous claims wherein said non-reciprocal means (5) comprises a circulator.

6. A method for determining the content of unburnt coal in an ash coming from a combustion heater, by the measurement of the dielectric constant of said ash, said ash loading a short-circuited microstrip (10) associated with microwave generating means (1) for providing a reference signal ($V_3$) and for feeding said microstrip with microwaves so that a reflected signal ($V_4$) is generated therefrom, the content of unburnt coal in the ash being a known function of the dielectric constant of the ash, said method being characterized in that it comprises the steps of:
- making the function between the reflection coefficient $\Gamma$ of said reflected signal and said dielectric constant numerically explicit;
- obtaining the modulus of said reflection coefficient by measuring the output power from the microstrip, respectively when said microstrip is loaded with said material and when it is not loaded, said modulus being given by

$$|\Gamma| = \frac{P\ \text{loaded}}{P\ \text{not loaded}} \;;$$

- measuring the phase of said reflection coefficient.

7. Method according to the claim 6, wherein the step of measuring the phase of said reflection coefficient comprises the steps of:
- feeding the same signal to a first circuit (2) for providing said reference signal ($V_3$) and to a second circuit comprising said microstrip (10) and a first phase shifter (6) and a second calibrated phase shifter (7);
- adjusting the phase difference between said reference and reflected signals by means of said first phase shifter (6) so as to make said difference equal to 90° when the microstrip is not loaded;
- measuring the phase angle $\phi$ of the reflection coefficient when the microstrip is not loaded;
- loading said microstrip with said ash;
- adjusting the phase difference between said reference and reflected signals by means of said second calibrated phase shifter (7), so as to make said difference equal to 90° again, and reading the relative phase displacement $\vartheta$ from said second calibrated phase shifter, whereby the total phase displacement can be obtained from $\gamma = \vartheta + \phi$, the angle $\gamma$ being the phase of the reflection coefficient.

## Revendications

1. Appareil pour le dosage de la teneur en charbon non brûlé dans des cendres provenant d'un appareil de chauffage par combustion, dans lequel ladite teneur est dosée par des moyens de mesure de la constante diélectrique desdites cendres, ledit appareil étant ***caractérisé en ce qu***'il comprend :
- une microbande (10) court-circuitée et des moyens de conteneur (9) associée à celle-ci pour maintenir lesdites cendres (11) en contact avec ladite microbande ;
- des moyens de production de micro-ondes (1) pour alimenter en micro-ondes ladite microbande (10) et pour fournir un signal de référence ($V_3$) ;
- des moyens non réciproques (5) pour extraire le signal réfléchi ($V_4$) de ladite microbande (10) ;
- des moyens (3, 4) pour détecter le décalage de phase entre ledit signal de référence ($V_3$) et ledit

signal ($V_4$) réfléchi par ladite microbande (10), lesdits moyens comprenant un mélangeur (3) et un voltmètre (4) ;
- des moyens de mesure (8) de la puissance appliquée à ladite microbande destinés à fournir le module de coefficient de réflexion ;
- des moyens de réglage (6, 7) pour faire varier ledit décalage de phase en faisant varier la phase entre ledit signal de référence ($V_3$) et ledit signal ($V_4$) réfléchi, lesdits moyens de réglage (6, 7) mesurant par une technique de compensation à zéro le décalage de phase entre lesdits signaux, grâce à quoi la valeur de la constante diélectrique peut être obtenue à partir du module de coefficient de réflexion et de la phase de ce dernier qui est fonction de ladite mesure de décalage de phase.

**2.** Appareil selon la Revendication 1, dans lequel lesdits moyens de conteneur (9) ont une paroi perpendiculaire à ladite microbande (10), la longueur de ladite paroi étant supérieure à une valeur minimum $d_1$ pour rendre le coefficient de réflexion indépendant de ce paramètre, ladite valeur $d_1$ étant fonction desdites cendres et de ladite microbande.

**3.** Appareil selon l'une quelconque des Revendications précédentes, dans lequel lesdits moyens pour détecter le décalage de phase entre les signaux de référence et les signaux réfléchis comprennent un mélangeur (3) ayant lesdits signaux comme grandeur d'entrée et un signal de tension égal à zéro comme grandeur de sortie, lorsque lesdits signaux sont en quadrature, et un voltmètre (4) pour détecter ledit signal de tension.

**4.** Appareil selon l'une quelconque des Revendications précédentes, dans lequel lesdits moyens de réglage comprennent un premier compensateur de phase (6) pour une phase de 90° décalant le signal réfléchi par la microbande, sous état non chargé, par rapport audit signal de référence, et un second compensateur de phase (7) pour une phase de 90° décalant le signal réfléchi par la microbande, sous état chargé, par rapport audit signal de référence.

**5.** Appareil selon l'une quelconque des Revendications précédentes, dans lequel lesdits moyens non réciproques (5) comprennent un circulateur.

**6.** Méthode pour le dosage de la teneur en charbon non brûlé dans des cendres provenant d'un appareil de chauffage par combustion, par la mesure de la constante diélectrique desdites cendres, lesdites cendres chargeant une microbande (10) court-circuitée associée à des moyens de production de micro-ondes (1) pour fournir un signal de référence ($V_3$) et pour alimenter ladite microbande en micro-ondes de façon qu'un signal réfléchi ($V_4$) en soit généré, la teneur en charbon non brûlé dans les cendres étant une fonction connue de la constante diélectrique des cendres, ladite méthode ***étant caractérisée en ce qu'***elle comprend les étapes consistant à :
- rendre numériquement explicite la fonction entre le coefficient de réflexion $\Gamma$ dudit signal réfléchi et de ladite constante diélectrique ;
- obtenir le module dudit coefficient de réflexion en mesurant la puissance en sortie de la microbande, respectivement lorsque la microbande est chargée avec ledit matériau et lorsqu'elle n'est pas chargée, ledit module étant donné par :

$$|\Gamma| = \frac{\text{P chargé}}{\text{P non chargé}} ;$$

- mesurer la phase dudit coefficient de réflexion.

**7.** Méthode selon la Revendication 6, dans laquelle l'étape de mesure de la phase dudit coefficient de réflexion comprend les étapes consistant à :
- introduire le même signal dans un premier circuit (2) pour fournir ledit signal de référence ($V_3$) et dans un second circuit comprenant ladite microbande (10) et un premier compensateur de phase (6) et un second compensateur de phase (7) étalonné ;
- régler la différence de phase entre lesdits signaux de référence et lesdits signaux réfléchis au

moyen dudit premier compensateur de phase (6) afin de rendre ladite différence égale à 90° lorsque la microbande n'est pas chargée ;
- mesurer l'angle de phase $\phi$ du coefficient de réflexion lorsque la microbande n'est pas chargée ;
- charger ladite microbande avec des cendres ;
- régler la différence de phase entre lesdits signaux de référence et lesdits signaux réfléchis au moyen dudit second compensateur de phase étalonné (7) afin de rendre ladite différence à nouveau égale à 90°, et à lire le décalage de phase correspondant $\vartheta$ dudit second compensateur de phase étalonné (7), grâce à quoi le décalage de phase total peut être obtenu par $\gamma = \vartheta + \phi$, l'angle $\gamma$ étant la phase du coefficient de réflexion.

**Patentansprüche**

1. Vorrichtung zur Bestimmung des Anteils unverbrannter Kohle in der bei einem Verbrennungsheizgerät anfallenden Asche durch Messung der Dielektrizitätskonstanten der Asche, **dadurch gekennzeichnet,** daß die Vorrichtung aufweist:
   - einen kurzgeschlossenen Mikrobandleiter (10) und ein ihm zugeordnetes Behältermittel (9), das die Asche im Kontakt mit dem Mikrobandleiter hält;
   - ein Mikrowellen erzeugendes Mittel (1) für die Zuführung von Mikrowellen zum Mikrobandleiter (10) und zur Erzeugung eines Referenzsignals ($V_3$);
   - ein nicht reziprokes Mittel (5) zur Aufnahme des vom Mikrobandleiter (10) reflektierten Signals ($V_4$);
   - ein Mittel zur Feststellung der Phasenverschiebung zwischen dem Referenzsignal ($V_3$) und dem vom Mikrobandleiter (10) reflektrierten Signal ($V_4$), wobei dieses Mittel einen Mischer (3) und ein Voltmeter (4) enthält;
   - ein Leistungsmeßmittel (8), das dem Mikrobandleiter zur Ermittlung des Umrechnungsfaktors des Reflexionskoeffizienten zugeordnet ist;
   - ein Steuermittel (6,7) zur Veränderung der Phasenverschiebung durch Veränderung der Phase zwischen Referenzsignal ($V_3$) und reflektiertem Signal ($V_4$) indem das Steuermittel (6,7) mittels einer Nulldurchgangstechnik die Phasenverschiebung zwischen den Signalen ermittelt, wobei der Wert der Dielektrizitätskonstanten aus dem jeweiligen Reflexionskoeffizienten und dessen Phase ermittelt werden kann, die eine Funktion der gemessenen Phasenverschiebung ist.

2. Vorrichtung nach Anspruch 1, bei der das Behältermittel (9) eine zum Mikrobandleiter (10) senkrechte Seite hat, deren Länge größer als ein Minimumwert (d) ist, um den Reflexionskoeffizienten von diesem Parameter unabhängig zu machen, wobei der Minimumwert (d) eine Funktion der Asche und des Mikrobandleiters ist.

3. Vorrichtung nach einem der vorstehenden Ansprüche, bei der das Steuermittel zum Ermitteln der Phasenverschiebung zwischen Referenz- und reflektiertem Signal einen Mischer (3) mit den Signalen als Eingang und einem Spannungssignal gleich Null als Ausgang einschließt, wenn die ersten Signale quadriert sind, wobei weiter ein Voltmesser (4) die Spannungssignale ermittelt.

4. Vorrichtung nach einem der vorstehenden Ansprüche, bei der das Steuermittel einen ersten Phasenschieber (6) für eine Phasenverschiebung des vom Mikrobandleiter reflektierten Signals um 90° unter Nichtbeladungsbedingung und bezüglich des Referenzsignals und einen zweiten kalibrierten Phasenschieber (7) zur Phasenverschiebung des vom Mikrobandleiters reflektierten Signals unter Beladungsbedingung und bezüglich des Referenzsignals einschließt.

5. Vorrichtung nach einem der vorstehenden Ansprüche, bei der das nicht reziproke Mittel (5) einen Zirkulator enthält.

6. Verfahren zur Bestimmung des Gehaltes unverbrannter Kohle in einer von einem Verbrennungsheizgerät stammenden Asche durch Messung der Dielektrizitätskonstanten dieser Asche, wobei die Asche auf einem kurzgeschlossenen Mikrobandleiter (10) deponiert wird, der einem mikrowellenerzeugenden Mittel (1) zugeordnet ist, um ein Referenzsignal ($V_3$) zu bilden und dem Mikrobandleiter Mikrowellen zuzuführen, so daß ein davon abgeleitetes Reflexionssignal ($V_4$) gebildet wird unter Nutzung des Umstandes, daß der Bestandteil an unverbrannter Kohle in der Asche eine bekannte Funktion der Dielektrizitätskonstanten der Asche ist, **gekennzeichnet** durch folgende Verfahrensschritte:

- Bilden der Funktion zwischen dem Reflexionskoeffizienten $\Gamma$ des reflektierten Signals und der Dielektrizitätskonstanten in zahlenmäßiger Ausdrucksweise;
- Erhalt des Umrechnungsfaktors des Reflexionskoeffizienten durch Messen der Ausgangsleistung des Mikrobandleiters einmal bei mit Material beladenem und einmal bei unbeladenem Mikrobandleiter, wobei der Umrechnungsfaktor aus folgender Beziehung zu ermitteln ist

$$|\Gamma| = \frac{P_{beladen}}{P_{unbeladen}}$$

- Messen der Phase des Reflexionskoeffizienten.

**7.** Verfahren nach Anspruch 6, wobei der Verfahrensschritt der Messung der Phase des Reflexionskoeffizienten folgende Schritte einschließt:
- Einspeisen desselben Signals in einen ersten Schaltkreis (2) zur Lieferung des Referenzsignals ($V_3$) und in einen zweiten Schaltkreis, der den Mikrobandleiter (10), einen ersten Phasenschieber (6) und einen zweiten, kalibrierten Phasenschieber (7) einschließt;
- Einstellen der Phasendifferenz zwischen Referenz- und reflektiertem Signal mittels des ersten Phasenschiebers (6), so daß bei unbeladenem Mikrobandleiter die Phasendifferenz 90° beträgt;
- Messen des Phasenwinkels $\phi$ des Reflexionskoeffizienten bei unbeladenem Mikrobandleiter.
- Aufbringen von Asche auf den Mikrobandleiter;
- Einstellen der Phasendifferenz zwischen Referenz- und reflektiertem Signal mittels des zweiten, kalibrierten Phasenschiebers (7), um die Phasendifferenz erneut auf 90° einzustellen und Ablesen der relativen Phasenverschiebung $\vartheta$ am zweiten, kalibrierten Phasenschieber, wobei die Gesamtphasenverschiebung aus der Beziehung $\gamma = \vartheta + \phi$ zu ermitteln ist, wobei der Winkel $\gamma$ die Phase des Reflexionskoeffizienten ist.

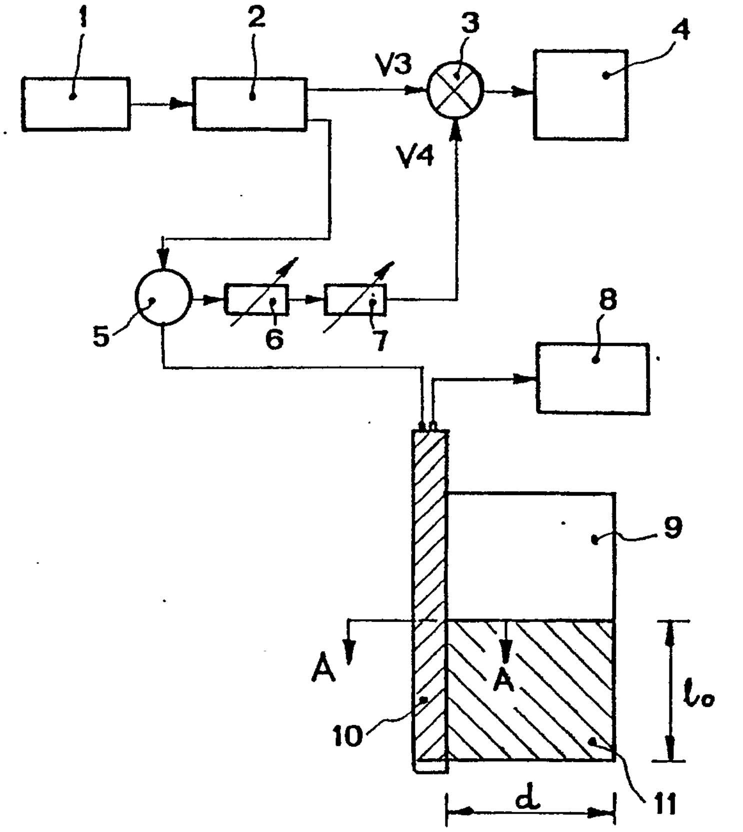


Fig.1

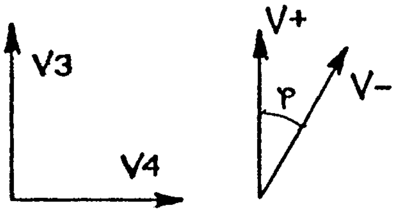


Fig.2

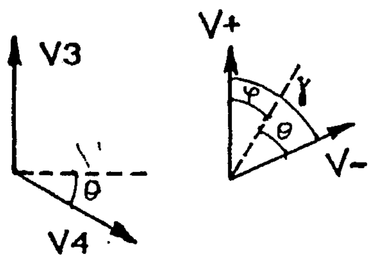


Fig.3